# EUROPÄISCHE PATENTSCHRIFT

(11) **EP 2 107 604 B1**
(45) Veröffentlichungstag und Bekanntmachung des Hinweises auf die Patenterteilung: **10.09.2014**
(21) Anmeldenummer: 09004421.5
(22) Anmeldetag: 27.03.2009
(51) Int. Cl.: H01L 23/29, H01L 23/538, H01L 21/60, H01L 23/00

(54) **Leistungshalbleitermodul mit hermetisch dichter Schaltungsanordnung und Herstellungsverfahren hierzu**
Power semiconductor module with hermetically sealed switching assembly and corresponding production method
Module semi-conducteur de puissance doté d'un circuit étanche hermétique et son procédé de fabrication

(30) Priorität: 05.04.2008 DE 102008017454
(43) Veröffentlichungstag der Anmeldung: 07.10.2009
(73) Patentinhaber: SEMIKRON Elektronik GmbH & Co. KG, 90431 Nürnberg (DE)
(72) Erfinder: Göbl, Christian, 90441 Nürnberg (DE); Braml, Heiko, 91346 Wiesenttal (DE)

(56) Entgegenhaltungen:
- WO-A1-2004/086502
- WO-A1-2005/096374
- WO-A1-2006/067021
- DE-A1- 1 594 165
- DE-A1-102004 057 421
- US-A- 5 637 922

## Beschreibung

Die Erfindung beschreibt ein Leistungshalbleitermodul und ein Herstellungsverfahren hierzu, wobei die Schaltungsanordnung des Leistungshalbleitermoduls hermetisch dicht gegen Umwelteinflüsse abgeschlossen ist. Speziell bei der Verwendung elektrischer Antriebe in Fahrzeugen oder anderen Anwendung in rauer Umgebung ist es vorteilhaft das Leistungshalbleitermodul besonders auszubilden. Diese Ausbildung sollte die Schaltungsanordnung des Leistungshalbleitermoduls vor den Einflüssen hoher Temperaturschwankungen besonders in Verbindung mit Feuchtigkeit zu schützen.

Bekannt sind Leistungshalbleitermodule gemäß der DE 196 17 055 C1 wobei zur inneren Isolierung des Leistungshalbleitermoduls sog. Prepregs offenbart sind. Hier und im Weiteren sollen unter Prepregs verschiedene Ausgestaltungen von Halbzeugen aus einem isolierenden Stoff und einer Kunststoffmatrix verstanden werden, die unter Druck- und/oder Temperaturbeaufschlagung aushärten und somit eine stoffschlüssige Verbindung mit mindestens einem Verbindungspartner ausbilden.

Ebenfalls, beispielhaft aus der DE 10 2004 021 927 A1 sind verschiedenartig angeordnete gelartige Isolierstoffe zu inneren Isolierung der Leistungshalbleitermodule bekannt. Gemäß dem Stand der Technik weisen diese Leistungshalbleitermodule ein Kunststoffgehäuse mit nach außen führenden Anschlusselementen für die Last- und Hilfsanschlüsse auf.

Beispielhaft aus der DE 103 55 925 A1 sind Verbindungseinrichtungen aus einer alternierenden Folge von leitenden und isolierenden Schichten zur schaltungsgerechten Verbindung der Schaltungsanordnung eines Leistungshalbleitermoduls bekannt. Derartige Verbindungseinrichtungen sind besonders bevorzugt für kompakte Aufbauten von Leistungshalbleitermodulen.

Eine grundsätzlich ähnlichen Ansatz verfolgt die WO 2006/067021. Hierbei wird zur Ausbildung einer Verbindungseinrichtung auf einem Substrat mit aufgebrachten Leistungshalbleiterbauelementen eine Kunststofffolie laminiert, die mit Aussparungen an zu kontaktierenden Stellen versehen ist. Die elektrisch leitende Verbindung wird dann durch auf der Kunststofffolie und den Ausnehmungen Abscheidung eines leitenden Werkstoffes hergestellt. Ferner offenbart sind zusätzliche, vom Substrat beabstandete, Versorgungsschienen, die mit Kontaktstellen auf dem Substrat oder der Verbindungseinrichtung elektrisch leitend verbunden ist.

Ebenso sind seit langem Scheibenzellen bekannt, die ein oder mehrere hermetisch gegen Umwelteinflüsse abgeschlossene Leistungshalbleiterbauelemente in ihrem Inneren aufweisen. Derartige Scheibenzellen weisen meist keine komplexen Schaltungsanordnungen, wie Dreiphasen-Brückenschaltungen, auf, wie sie von Leistungshalbleitermodulen mit Kunststoffgehäusen bekannt sind.

Der Erfindung liegt die Aufgabe zugrunde ein Leistungshalbleitermodul und ein Herstellungsverfahren hierzu anzugeben, wobei die Schaltungsanordnung des Leistungshalbleitermoduls hermetisch gegen Umwelteinflüsse abgedichtet ist und wobei die Schaltungsanordnung gleichzeitig einer flexiblen Ausgestaltung bei einfacher Herstellbarkeit zugänglich ist.

Diese Aufgabe wird erfindungsgemäß gelöst, durch ein Leistungshalbleitermodul mit den Merkmalen des Anspruchs 1 sowie durch ein Herstellungsverfahren gemäß Anspruch 3. Bevorzugte Ausführungsformen sind in den abhängigen Ansprüchen beschrieben.

Ausgangspunkt der Erfindung ist eine Schaltungsanordnung eines Leistungshalbleitermoduls mit einem Substrat, mit hierauf angeordneten Leiterbahnen und hierauf angeordneten Leistungshalbleiterbauelementen und einer hierzu angeordneten Verbindungseinrichtung. Hierbei wird unter Schaltungsanordnung die Summe aller für die elektrische Funktion notwendigen Leiterbahnen und Halbleiterbauelemente verstanden. Als Verbindungseinrichtung dient hierbei eine alternierende Schichtfolge mindestens zweier elektrisch leitender Schichten und mindestens einer elektrisch isolierenden Schicht. Die Leiterbahnen der Schaltungsanordnung sind auf dem Substrat ausgebildet und gegeneinander elektrisch isoliert. Sie tragen die Leistungshalbleiterbauelemente und bilden einen Teil der schaltungsgerechten Verbindungen der Leistungshalbleiterbauelemente. Die weiteren schaltungsgerechten Verbindungen werden mittels der Verbindungseinrichtung ausgebildet. Hierzu ist mindestens eine der elektrisch leitenden Schichten in sich strukturiert und bildet Verbindungsbahnen aus. Es kann ebenso bevorzugte sein, wenn zwischen verschiedenen elektrisch leitenden Schichten Durchkontaktierungen vorgesehen sind.

Erfindungsgemäß weist das Substrat eine erste die Schaltungsanordnung unterbrechungsfrei umschließende Dichtfläche auf. Diese kann als Rahmen um die Schaltungsanordnung ausgestaltet sein und beispielhaft als eine metallische Schicht analog den Leiterbahnen ausgebildet sein. Diese erste Dichtfläche ist mittels einer Verbindungsschicht mit einer zugeordneten zweiten Dichtfläche der Verbindungseinrichtung auf einer metallischen Schicht, hermetisch dicht verbunden. Diese Verbindung ist als eine Drucksinterverbindung ausgebildet.

Das erfindungsgemäße Verfahren zu Ausbildung eines derartigen Leistungshalbleitermoduls ist durch die folgenden wesentlichen Schritte gekennzeichnet:
- Anordnen der Leistungshalbleiterbauelemente auf den zugeordneten Leiterbahnen des Substrats, wobei hierbei eine Sintermetallschicht zwischen dem jeweiligen Leistungshalbleiterbauelement und er zugeordneten Fläche auf der Leiterbahn angeordnet wird;
- Anordnen der die Schaltungsanordnung unterbrechungsfrei Umschließenden Verbindungsschicht, ausgebildet als Sintermetallschicht auf der ersten Dichtfläche, wobei die erste Dichtfläche die Schaltungsanordnung umläuft und die Schaltungsanordnung unterbrechungsfrei umschließt;
- Anordnen der die Schaltungsanordnung unterbrechungsfrei Umschließenden Verbindungseinrichtung zu den Leistungshalbleiterbauelementen, zu der ersten Dichtfläche und zu dem Substrat; hierbei wird selbstverständlich auch die zweite Dichtfläche zur Verbindungsschicht und damit auch zur ersten Dichtfläche ausgerichtet;
- Druck- und vorzugsweise auch Temperaturbeaufschlagung auf das Substrat, auf die Leistungshalbleiterbauelemente und auf die Verbindungseinrichtung, wodurch die Drucksinterverbindung zwischen der ersten und zweiten Dichtfläche ausgebildet wird, wobei die Verbindungsschicht eine Sintermetallschicht ist und deren stoffschlüssig Verbindung mit der ersten metallisch ausgebildeten Dichtfläche und der zugeordneten zweiten Dichtfläche auf einer metallischen Schicht der Verbindungseinrichtung gleichzeitig mit der Sinterverbindung der Leistungshalbleiterbauelemente mit den Leiterbahnen und der ersten metallischen Schicht der Verbindungseinrichtung ausgebildet wird.

Hierbei kann es besonders bevorzugt sein, wenn nach der Anordnung der Leistungshalbleiterbauelement vollständig um diese herum und umlaufend auf dem Rand der dem Substrat abgewandten Hauptfläche ein gelartiger Isolierstoff, beispielhaft ein Silikongel, angeordnet wird.

Besonders bevorzugte Weiterbildungen dieser Schaltungsanordnung sind in der jeweiligen Beschreibung der Ausführungsbeispiele genannt. Die erfinderische Lösung wird zudem an Hand der Ausführungsbeispiele und der Fig. 1 bis 8 weiter erläutert.
Fig. 1 zeigt einen Ausschnitt aus einem Leistungshalbleitermodul mit einer Verbindungseinrichtung nach dem Stand der Technik in Seitenansicht.
Fig. 2 zeigt einen Ausschnitt aus einem Leistungshalbleitermodul mit einer Verbindungseinrichtung nach dem Stand der Technik in Draufsicht.
Fig. 3 zeigt einen Ausschnitt einer ersten Ausgestaltung eines erfindungsgemäßen Leistungshalbleitermoduls in Seitenansicht.
Fig. 4 zeigt einen Ausschnitt eines Leistungshalbleitermoduls in Seitenansicht.
Fig. 5 zeigt einen Ausschnitt eines Leistungshalbleitermoduls in Seitenansicht.
Fig. 6 zeigt eine Draufsicht auf ein Substrat eines erfindungsgemäßen Leistungshalbleitermoduls.
Fig. 7 zeigt einen Ausschnitt einer ersten Verbindungseinrichtung eines erfindungsgemäßen Leistungshalbleitermoduls.
Fig. 8 zeigt einen Ausschnitt einer zweiten Verbindungseinrichtung eines erfindungsgemäßen Leistungshalbleitermoduls.

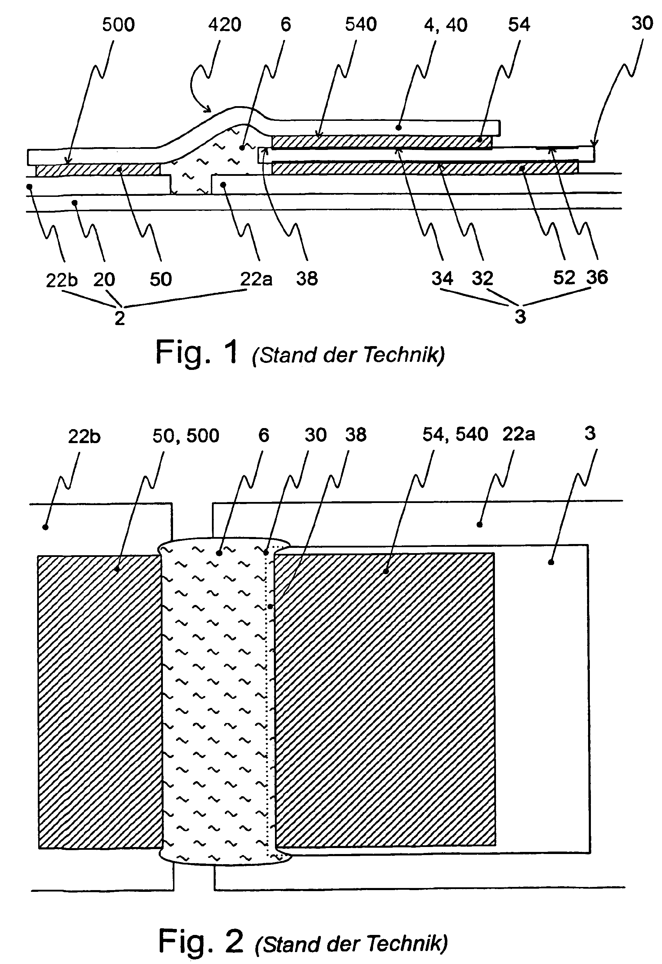

Fig. 1 zeigt einen Ausschnitt aus einem Leistungshalbleitermodul mit einer Verbindungseinrichtung (4) nach dem Stand der Technik in Seitenansicht. Auf eine Darstellung des Gehäuses und der notwendigen externen Last- und Hilfsanschlusselemente wird hier und bei allen folgenden Abbildungen verzichtet. Dargestellt ist hierbei ein Substrat (2), wie es häufig als sog. DCB- (direct copper bonding) oder IMS- (insulated metal substrate) Substrat bekannt ist, ohne dass diese eine Beschränkung auf derartige Substrate bedeuten soll. Das Substrat (2) weist eine isolierende Lage (20) mit hierauf angeordneten und elektrisch voneinander isolierten Leiterbahnen (22 a/b) auf. Eine dieser Leiterbahnen (22a) trägt hier ein ungehaustes Halbleiterbauelement (3), beispielsweise einen Leistungstransistor wie er beispielhaft zur Ansteuerung von Drehstrommotoren eingesetzt wird.

Zur elektrisch leitenden Verbindung zwischen der ersten das Halbleiterbauelement (3) tragenden Leiterbahn (22a) und einer zugeordneten Kontaktfläche (32) auf der ersten Hauptfläche des Halbleiterbauelements (3) ist eine Sintermetallschicht (52) angeordnet. Diese Sintermetallschicht (52) stellt nach dem Drucksinterprozess der Herstellung eine elektrisch leitende Verbindung hoher Zuverlässigkeit dar.

Die zweite Hauptfläche des Halbleiterbauelements (3) weist zwei Kontaktflächen (34, 36) auf. Eine erste großflächige Emitteranschlussfläche (34) und eine weitere kleinere Gateanschlussfläche (36). Auf der Emitteranschlussfläche (34) ist wiederum eine Sintermetallschicht angeordnet. Diese dient der elektrischen Verbindung der Emitteranschlussfläche (34) mit der Verbindungseinrichtung 4.

Die Verbindungseinrichtung (4) ist hier als metallische Folie (40), vorzugsweise aus Kupfer mit Edelmetallbeschichtung im Bereich der Sinterverbindungen (50, 52) ausgebildet. Die Dicke dieser metallischen Folie (40) ist derart gewählt, dass sie mindestens die gleiche Stromtragfähigkeit aufweist wie eine Drahtbondverbindung gemäß dem Stand der Technik.

Die Verbindungseinrichtung (4) stellt die elektrisch leitende Verbindung zwischen der Emitteranschlussfläche (34) des Halbleiterbauelements (3) und einer zweiten Leiterbahn (22b) des Substrats (2) dar. Die Verbindung der Verbindungseinrichtung (4) zur zweiten Leiterbahn (22b) ist ebenfalls als Drucksinterverbindung ausgebildet. Vorzugsweise weist die metallische Folie (40) einen bogenförmigen Verlauf (420) zwischen den beiden Kontaktflächen auf.

In dem Volumenbereich der durch den bogenförmigen Verlauf (420) der Verbindungseinrichtung (4), dem Substrat (2) und dem Halbleiterbauelement (3) gebildet wird ist ein Isolierstoff (6) angeordnet. Dieser Isolierstoff wurde während des Herstellungsprozesses in demjenigen Bereiche aufgebracht der anschließend von einer Verbindungseinrichtung (4) überdeckt wird. Bei dieser Ausgestaltung ist dies der Bereich neben dem seitlichen Rand (30) des Halbleiterbauelements (3) sowie ein äußerer Teil des oberen Randes (38), vgl. Fig. 2.

Vorzugsweise ist der verwendete Isolierstoff (6) eine mehrkomponentige Silikonverbindung, die in einem Dosier- oder Gießverfahren am Rand des Halbleiterbauelements (3) aufgetragen wurde und mittels einer UV- Belichtung vernetzt wurde. Somit ist einerseits eine gewisse Zähigkeit des Isolierstoffs (6) gegeben, und andererseits eignet sich eine derartige Silikonverbindung auch zur inneren Isolation, falls die Schaltungsanordnung für entsprechend hohe Spannungen entworfen wurde.

Fig. 2 zeigt einen Ausschnitt aus einem Leistungshalbleitermodul mit einer Verbindungseinrichtung nach dem Stand der Technik in Draufsicht. Dargestellt sind hierbei die gleichen Teile der Schaltungsanorndung wie unter Fig. 1 beschrieben.

Hierbei ist die flächige Ausdehnung des Isolierstoffes (6) im Bereich zwischen den Kontaktflächen (500, 540) der Verbindungseinrichtung (4) mit der Leiterbahn (22b) sowie dem Halbleiterbauelement (3) bzw. dessen Emitteranschlussfläche (34) sowie auch im Bereich neben der Verbindungseinrichtung (4) dargestellt.

Gemäß dieser Ausgestaltung dient der Isolierstoff (6) einerseits bei einer flächigen Druckeinleitung im Rahmen der Drucksinterverbindung in Richtung der Zeichnungsebene als quasihydostatisches Element, das den Druck auf an seinen Grenzflächen gleichmäßig verteilt und somit einer Beschädigung des Halbleiterbauelement während der Druckbeaufschlagung verhindert. Anderseits dienst es auch der bereits beschrieben elektrischen Isolation der Schaltungsanordnung des erfindungsgemäßen Leistungshalbleitermoduls.

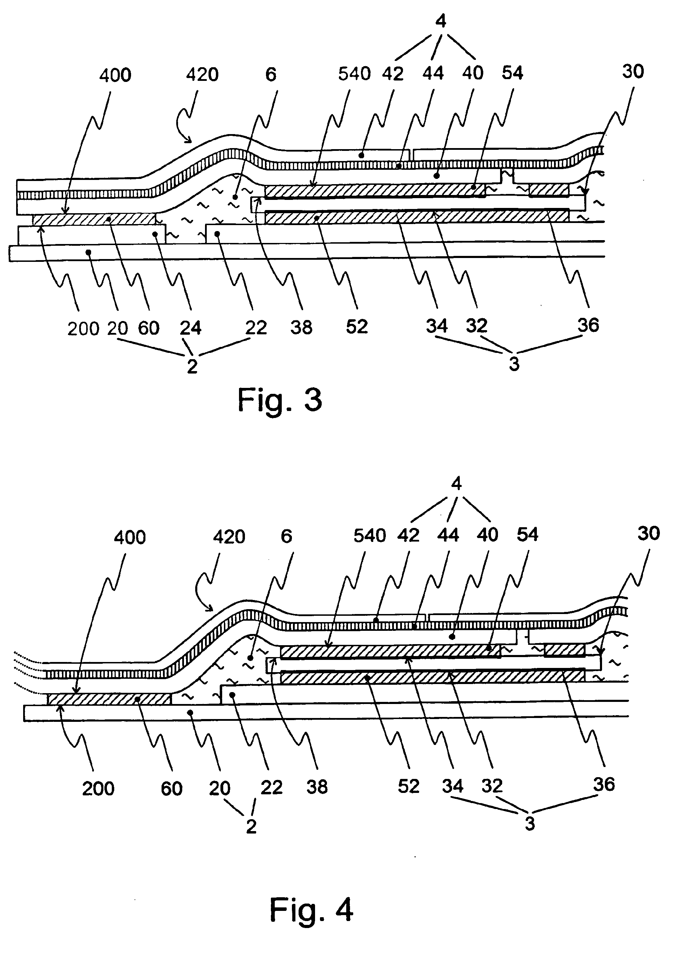

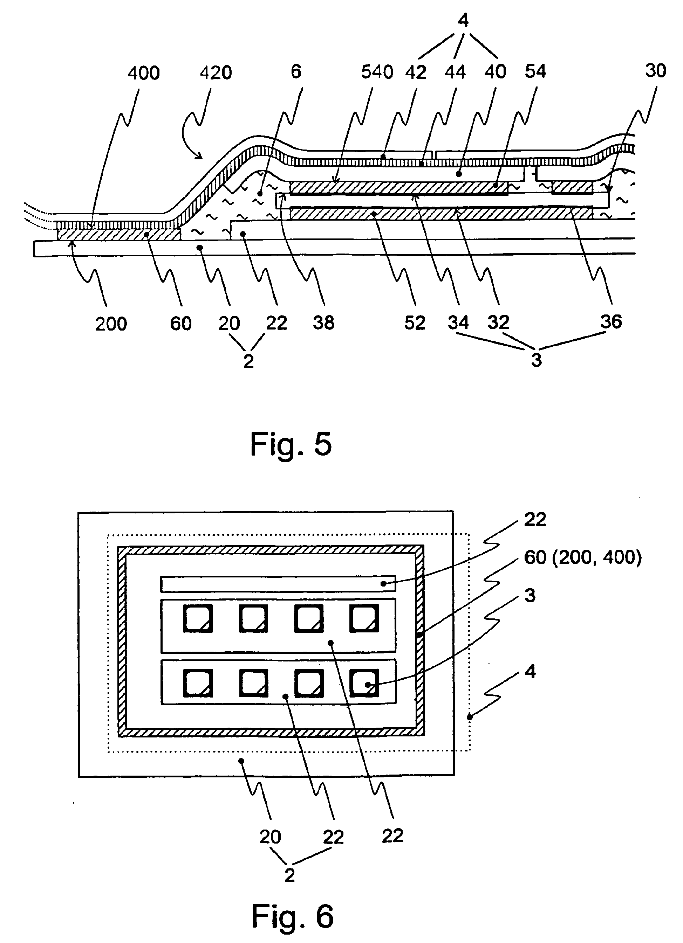

Fig. 3 zeigt einen Ausschnitt einer ersten Ausgestaltung eines erfindungsgemäßen Leistungshalbleitermoduls in Seitenansicht. Der grundlegende Aufbau des Substrats (2), wie auch des auf der Leiterbahn (22) angeordneten Leistungshalbleiterbauelements (3) ist identisch demjenigen unter Fig. 1 beschrieben. Die Verbindungseinrichtung (4) weist hier allerdings einen alternierenden Aufbau aus mindestens drei Schichten auf, wobei die Schichtfolge vom Substrat (2) aus betrachtet mit einer ersten elektrisch leitenden Schicht (40) beginnt, auf die eine erste isolierende (44) und dann wieder eine leitende Schicht (42) folgt. Die Verbindungseinrichtung (4) erstreckt sich hierbei über die gesamt Schaltungsanordnung und über die erste Dichtfläche (200) hinaus, vgl. Fig. 6.

Erfindungsgemäß weist das Substrat (2) eine erst umlaufend um die Schaltungsanordnung ausgebildete Dichtfläche (200) auf, die hier auf einer analog den Leiterbahnen (22) ausgebildeten metallischen Schicht (24) angeordnet ist. Gemäß dem erfindungsgemäßen Verfahren zur Herstellung eines derartigen Leistungshalbleitermoduls wird auf der ersten, hier metallischen Dichtfläche (200) eine Sintermetallschicht (60) angeordnet, die in einem Drucksinterverfahren mit der zweiten Dichtfläche (400), die hier auf der ersten leitenden Schicht (40) der Verbindungseinrichtung (4) angeordnet ist verbunden. Zur Ausbildung diese Sinterverbindungen ist es selbstverständlich bevorzugt die Verbindungspartner, also die erste (200) und zweite Dichtfläche (400) mit einer Edelmetallbeschichtung zu versehen. Es ist besonders bevorzugt in einem Arbeitsschritt mehrere Sinterverbindungen gleichzeitig auszubilden, also sowohl die Sinterverbindungen der beiden Dichtflächen (200, 400) sowie auch die Sinterverbindungen des Leistungshalbleiterbauelements (3), also die Verbindung zur zugeordneten Leiterbahn (22) als auch zur ersten metallischen Schicht (40) der Verbindungseinrichtung (4).

Weiterhin dargestellt ist, dass umlaufend um die jeweiligen Leistungshalbleiterbauelemente (3), vorteilhafterweise bis heran an die erste Dichtfläche (200) ein gelartiger Isolierstoff (6) angeordnet ist. Dieser umschließt das Leistungshalbleiterbauelement (3) nicht nur an seinem äußeren Rand (30) sondern überdeckt auch dessen dem Subrat abgewandte Hauptfläche an ihrem Rand (38).

Fig. 4 zeigt einen Ausschnitt eines Leistungshalbleitermoduls in Seitenansicht. Die Ausbildung des Leistungshalbleiterbauelements (3) sowie der Aufbau der Verbindungseinrichtung (4) sind weitgehend identisch demjenigen unter Fig. 3 beschrieben. Die Verbindungseinrichtung ragt hier allerdings an der dem Leistungshalbleiterbauelement (3) abgewandten Seite zumindest teilweise weiter über die erste Dichtfläche (200) hinaus, um beispielhaft mit Anschlusselementen für externe Last- und Hilfsanschlüsse verbunden zu werden.

Das Substrat (2) weist hier als erste Dichtfläche (200) allerdings keine metallische Schicht auf, sondern ausschließlich einen die Schaltungsanordnung vollständig umschließenden frei gesparten Bereich des Grundkörpers (20) des Substrats (2), also bei einem DCB- Substrat einen Bereich auf der Keramik.

Hier kann nun als Verbindungsschicht (60) wiederum Sintermetall verwendet werden, wobei dann allerdings auf der jeweiligen Dichtfläche (200, 400) eine Edelmetallbeschichtung abgeschieden werden müsste. Alternativ und bevorzugt wird hier als Verbindungsschicht (60) ein Prepreg eingesetzt, das rahmenartig um die Schaltungsanordnung herum angeordnet ist und die Schaltungsanordnung somit vollständig umschließt (vgl. Fig. 6). Im Rahmen der Sinterverbindungen des Leistungshalbleiterbauelements (3) wird hierbei gleichzeitig auch die Verbindung des Prepregs (60) mit der ersten (200) und zweiten Dichtfläche (400) erstellt, wobei die zweite Dichtfläche (400) hier wiederum eine Teilfläche der ersten elektrisch leitenden Schicht (40) der Verbindungseinrichtung (4) ist.

Fig. 5 zeigt einen Ausschnitt eines Leistungshalbleitermoduls in Seitenansicht. Diese unterscheidet sich von der zweiten Ausgestaltung gemäß Fig. 4 dahingehend, dass die zweite Dichtfläche (400) Teilfläche der ersten isolierenden Schicht (44) der Verbindungseinrichtung (4) ist. Die Verbindungsschicht (60) ist hier vorteilhafterweise als Prepreg ausgebildet.

Fig. 6 zeigt eine Draufsicht auf ein Substrat (2) eines erfindungsgemäßen Leistungshalbleitermoduls. Dargestellt ist hierbei das Substrat (2) mit der Schaltungsanordnung bestehend aus drei Leiterbahnen (22) und auf zwei dieser Leiterbahnen angeordneten Leistungshalbleiterbauelementen (3). Ebenfalls schematisch dargestellt ist die Verbindungsschicht (4), die deckungsgleich mit der umlaufenden ersten Dichtfläche (200) auf dem Substrat (2) und der zweiten Dichtfläche (400) auf der Verbindungseinrichtung (4) ist.

Die schaltungsgerechte Verbindung der Leistungshalbleiterbauelemente (3) miteinander oder mit einer weiteren Leiterbahn (22) erfolgt durch die nur im Umriss dargestellte Verbindungseinrichtung (4). Es ist hierbei ersichtlich, dass diese erfindungsgemäß die gesamte Schaltungsanordnung und die erste Dichtfläche (200) überragt, um einen hermetisch dichten Abschluss der Schaltungsanordnung gegenüber Umwelteinflüssen zu erreichen.

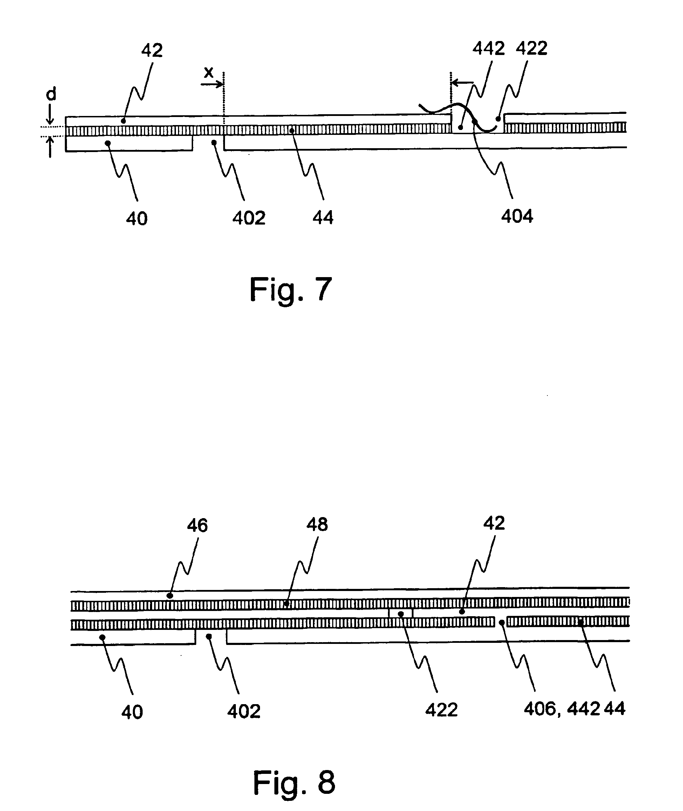

Fig. 7 zeigt einen Ausschnitt einer ersten Verbindungseinrichtung (4) eines erfindungsgemäßen Leistungshalbleitermoduls. Dargestellt ist hierbei eine Durchkontaktierung (404) von der unterbrochenen (422) zweiten elektrisch leitenden Schicht (42) durch eine Ausnehmung (442) der isolierenden Schicht (44) zur ersten elektrisch leitenden Schicht (40). Diese ist hier ausgebildet als eine Drahtbondverbindung (404). Ebenfalls dargestellt ist eine Unterbrechung (402) der ersten elektrisch leitenden Schicht (40), beispielhaft zur Erzeugung zweier voneinander isolierter Verbindungsbahnen für den Emitteranschluss und den Gateanschluss eines Leistungshalbleiterbauelements, vgl. Fig. 3 bis 5).

Zum hermetischen Abschluss der Schaltungsanordnung kann es nicht nur notwendig sein, die umlaufenden ersten und zweiten Dichtflächen miteinander zu verbinden, sondern auch einen Abstand (x) zwischen Öffnungen (402, 422) der elektrisch leitenden Schichten (40, 42) vorzusehen. Es ist somit besonders bevorzugt, wenn zwei derartige Öffnungen (40, 42) einen Abstand (x) voneinander aufweisen, der mindestens das Zehnfache der Dicke (d) der zwischen den elektrisch leitenden Schichten (40, 42) angeordnete isolierende Schicht (44) aufweist.

Fig. 8 zeigt einen Ausschnitt einer zweiten Verbindungseinrichtung (4) eines erfindungsgemäßen Leistungshalbleitermoduls. Dargestellt ist hier eine Verbindungseinrichtung mit drei elektrisch leitenden Schichten (40, 42, 46) und zwei jeweils dazwischen angeordneten isolierenden Schichten (44, 48). Die erste und zweite elektrisch leitende Schicht (40, 42) weist zur schaltungsgerechten Verbindung Durchkontaktierungen (406) auf, während die dritte elektrisch leitende Schicht (46) nicht unterbrochen ist und beispielhaft der Abschirmung der Schaltungsanordnung dienen kann.

Jede der einzelnen Schichten dieser Verbindungseinrichtung besonders aber auch die dritte ununterbrochene elektrisch leitfähige Schicht (46) ist geeignet, um hierauf die zweite Dichtfläche (400) anzuordnen.

## Patentansprüche

1. Leistungshalbleitermodul mit einem Substrat (2) und einer hierauf ausgebildeten Schaltungsanordnung mit einer Mehrzahl gegeneinander elektrisch isolierter Leiterbahnen (22), wobei die Schaltungsanordnung auf den Leiterbahnen (22) angeordnete Leistungshalbleiterbauelemente (3) aufweist, die mittels einer Verbindungseinrichtung (4), bestehend aus einer alternierenden Schichtfolge mindestens zweier elektrisch leitender Schichten (40, 42, 46) und mindestens einer elektrisch isolierenden Schicht (44, 48), schaltungsgerecht verbunden sind wobei das Substrat (2) eine umlaufend um die Schaltungsanordnung ausgebildete, die Schaltungsanordnung unterbrechungsfrei umschließende erste Dichtfläche (200) aufweist und diese Dichtfläche (200) mittels einer die Schaltungsanordnung unterbrechungsfrei umschließenden Verbindungsschicht (60) mit einer zugeordneten die Schaltungsanordnung unterbrechungsfrei umschließenden zweiten Dichtfläche (400) auf einer Schicht der Verbindungseinrichtung (4) verbunden ist, wobei die erste Dichtfläche (200) auf einer metallischen Schicht (24) angeordnet ist und mittels einer Drucksinterverbindung und einer Sintermetallschicht als Verbindungsschicht (60) mit einer elektrisch leitenden Schicht (40, 42, 46) der Verbindungseinrichtung (4) hermetisch dicht verbunden ist.

2. Leistungshalbleitermodul nach Anspruch 1,
wobei umlaufend um die jeweiligen Leistungshalbleiterbauelemente (3) ein gelartiger Isolierstoff (6) angeordnet ist.

3. Herstellungsverfahren für ein Leistungshalbleitermodul nach Anspruch 1, **gekennzeichnet durch** die wesentlichen Schritte:
• Anordnen der Leistungshalbleiterbauelemente (3) auf den zugeordneten Leiterbahnen (22) des Substrats (2);
• Anordnen der die Schaltungsanordnung unterbrechungsfrei umschließenden Verbindungsschicht (60) auf der ersten Dichtfläche (200), wobei die erste Dichtfläche (200) die Schaltungsanordnung umläuft und die Schaltungsanordnung unterbrechungsfrei umschließt;
• Anordnen der die Schaltungsanordnung unterbrechungsfrei umschließenden Verbindungseinrichtung (4) zu den Leistungshalbleiterbauelementen (3), zu der ersten Dichtfläche (200) und zu den Leiterbahnen (22) des Substrats (2);
• Druckbeaufschlagung auf das Substrat (2), auf die Leistungshalbleiterbauelemente (3) und auf die Verbindungseinrichtung (4), wobei die Verbindungsschicht (60) eine Sintermetallschicht ist und deren stoffschlüssig Verbindung mit der ersten metallisch ausgebildeten Dichtfläche (200) und der zugeordneten zweiten Dichtfläche (400) auf einer metallischen Schicht (40, 42, 46) der Verbindungseinrichtung (4) gleichzeitig mit der Sinterverbindung der Leistungshalbleiterbauelemente (3) mit den Leiterbahnen (22) und der ersten metallischen Schicht (40) der Verbindungseinrichtung (4) ausgebildet wird.

4. Herstellungsverfahren nach Anspruch 3,
wobei nach der Anordnung der Leistungshalbleiterbauelemente (3) um diese (30) und den Rand (38) der dem Substrat (2) abgewandten Hauptfläche bedeckend ein gelartiger Isolierstoff (6) angeordnet wird

## Claims

1. A power semiconductor module with a substrate (2) and a circuit arrangement arranged on the latter with a multiplicity of conducting tracks (22) electrically insulated from one another, wherein the circuit arrangement has power semiconductor components (3) arranged on the conducting tracks (22), which by means of a connecting device (4), consisting of an alternating sequence of layers with at least two electrically conducting layers (40, 42, 46) and at least one electrically insulating layer (44, 48), are connected in accordance with circuit requirements, wherein the substrate (2) has a first sealing surface (200) formed peripherally around the circuit arrangement, and enclosing the circuit arrangement in a manner free of discontinuities, and this sealing surface (200) is connected by means of a connecting layer (60), enclosing the circuit arrangement in a manner free of discontinuities, with an associated second sealing surface (400) on a layer of the connecting device (4), enclosing the circuit arrangement in a manner free of discontinuities, wherein the first sealing surface (200) is arranged on a metallic layer (24), and by means of a pressure-sintered joint and a sintered metal layer as a connecting layer (60) is hermetically sealed with an electrically conducting layer (40, 42, 46) of the connecting device (4).

2. The power semiconductor module according to claim 1, wherein
a gel-type insulation substance (6) is arranged peripherally around the respective power semiconductor components (3).

3. A manufacturing method for a power semiconductor module according to claim 1, **characterised by** the essential steps:
• Arrangement of the power semiconductor components (3) on the associated conducting tracks (22) of the substrate (2);
• Arrangement of the connecting layer (60), enclosing the circuit arrangement in a manner free of discontinuities, on the first sealing surface (200), wherein the first sealing surface (200) runs peripherally around the circuit arrangement, and encloses the circuit arrangement in a manner free of discontinuities;
• Arrangement of the connecting device (4), enclosing the circuit arrangement in a manner free of discontinuities, with the power semiconductor components (3), with the first sealing surface (200), and with the conducting tracks (22) of the substrate (2);
• Application of pressure onto the substrate (2), onto the power semiconductor components (3) and onto the connecting device (4), wherein the connecting layer (60) is a sintered metal layer and its material bond with the first metallically formed sealing surface (200) and the associated second sealing surface (400) on a metallic layer (40, 42, 46) of the connecting device (4) is formed at the same time as the sintered joint of the power semiconductor components (3) with the conducting tracks (22) and the first metallic layer (40) of the connecting device (4).

4. The manufacturing method according to claim 3, wherein after the arrangement of the power semiconductor components (3) a gel-type insulating substance (6) is arranged in a covering manner around these (30) and the edge (38) of the main surface facing away from the substrate (2).

## Revendications

1. Module semi-conducteur de puissance comportant un substrat (2) et un montage de circuit formé sur celui-ci avec une pluralité de pistes conductrices (22) isolées les unes par rapport aux autres, le montage de circuit présentant des composants semi-conducteurs de puissance (3) disposés sur les pistes conductrices (22), reliés pour former le circuit au moyen d'un dispositif de connexion (4) constitué d'une série de couches alternées comprenant au moins deux couches électroconductrices (40, 42, 46) et au moins une couche électriquement isolante (44, 48), le substrat (2) comportant une première surface d'étanchéité (200) réalisée périphériquement au montage de circuit et entourant le montage de circuit sans interruption, et ladite surface d'étanchéité (200) étant reliée par une couche de liaison (60) entourant le montage de circuit sans interruption à une deuxième surface d'étanchéité (400) correspondante entourant le montage de circuit sans interruption sur une couche du dispositif de connexion (4), la première surface d'étanchéité (200) étant disposée sur une couche métallique (24) et étant raccordée de manière étanche, en tant que couche de liaison (60), à une couche électroconductrice (40, 42, 46) du dispositif de connexion (4) au moyen d'une liaison par frittage sous pression et d'une couche métallique frittée.

2. Module semi-conducteur de puissance selon la revendication 1,
dans lequel une matière isolante (6) de type gel est disposée périphériquement à chaque composant semi-conducteur de puissance (3).

3. Procédé de fabrication pour un module semi-conducteur de puissance selon la revendication 1, **caractérisé par** ses étapes principales :
• disposition des composants semi-conducteurs de puissance (3) sur les pistes conductrices (22) correspondantes du substrat (2) ;
• disposition de la couche de liaison (60) entourant le montage de circuit sans interruption sur la première surface d'étanchéité (200), ladite première surface d'étanchéité (200) étant périphérique au montage de circuit et entourant le montage de circuit sans interruption ;
• disposition du dispositif de connexion (4) entourant le montage de circuit sans interruption sur les composants semi-conducteurs de puissance (3), sur la première surface d'étanchéité (200) et sur les pistes conductrices (22) du substrat (2) ;
• application de pression sur le substrat (2), sur les composants semi-conducteurs de puissance (3) et sur le dispositif de connexion (4), la couche de liaison (60) étant une couche métallique frittée dont la liaison par accouplement de matière avec la première surface d'étanchéité (200) réalisée métalliquement et la deuxième surface d'étanchéité (400) correspondante est réalisée sur une couche métallique (40, 42, 46) du dispositif de connexion (4) simultanément à la liaison par frittage des composants semi-conducteurs de puissance (3) avec les pistes conductrices (22) et la première couche métallique (40) du dispositif de connexion (4).

4. Procédé de fabrication selon la revendication 3, dans lequel, après disposition des composants semi-conducteurs de puissance (3), une matière isolante (6) de type gel est disposée autour de ceux-ci (30) et en couvrant le bord (38) de la surface principale distante du substrat (2) .
